# EUROPÄISCHE PATENTSCHRIFT

(11) **EP 3 348 118 B1**
(45) Veröffentlichungstag und Bekanntmachung des Hinweises auf die Patenterteilung: **08.05.2024**
(21) Anmeldenummer: 16745606.0
(22) Anmeldetag: 19.07.2016
(51) Int. Cl.: G01K 7/42, G01R 31/26

(54) **VERFAHREN ZUR ÜBERWACHUNG EINES HALBLEITERMODULS**
METHOD FOR MONITORING A SEMICONDUCTOR MODULE
PROCÉDÉ POUR LA SURVEILLANCE D'UN MODULE SEMI-CONDUCTEUR

(30) Priorität: 07.09.2015 AT 507662015
(43) Veröffentlichungstag der Anmeldung: 18.07.2018
(73) Patentinhaber: Materials Center Leoben Forschung GmbH, 8700 Leoben (AT)
(72) Erfinder: DEFREGGER, Stefan, 8501 Lieboch (AT); KRAKER, Elke, 8010 Graz (AT); MÜCKE, Manfred, 8010 Graz (AT)
(74) Vertreter: Wirnsberger & Lerchbaum Patentanwälte OG
(86) Internationale Anmeldenummer: PCT/AT2016/050250
(87) Internationale Veröffentlichungsnummer: WO 2017/041123

(56) Entgegenhaltungen:
- WO-A1-2015/021726
- WO-A2-2010/031103
- DE-A1-102007 009 532
- WEI HUANG ET AL: "Parameterized physical compact thermal modeling", IEEE TRANSACTIONS ON COMPONENTS AND PACKAGING TECHNOLOGIES, IEEE SERVICE CENTER, PISCATAWAY, NJ, US, Bd. 28, Nr. 4, 1. Dezember 2005 (2005-12-01), Seiten 615-622, XP001512502, ISSN: 1521-3331, DOI: 10.1109/TCAPT.2005.859737
- K. Mainka, M. Thobe: "Messung von transienten thermischen Widerständen", elektroniknet.de, 22. Oktober 2013 (2013-10-22), Seite 7PP, XP002761592, Gefunden im Internet: URL:http://www.elektroniknet.de/power/powe r-management/artikel/102189 [gefunden am 2016-09-08]
- POPPE A ET AL: "Multi-domain simulation and measurement of power LED-s and power LED assemblies", SEMICONDUCTOR THERMAL MEASUREMENT AND MANAGEMENT SYMPOSIUM, TWENTY-SECOND ANNUAL IEEE DALLAS, TX USA MARCH 14-16, 2006, PISCATAWAY, NJ, USA,IEEE, 14. März 2006 (2006-03-14), Seiten 191-198, XP010912403, DOI: 10.1109/STHERM.2006.1625227 ISBN: 978-1-4244-0153-6

## Beschreibung

Die Erfindung betrifft ein Verfahren zur Überwachung eines Halbleitermoduls, insbesondere eines LED-Moduls, gemäß dem Oberbegriff des Anspruchs 1.

Aus dem Stand der Technik ist es bekannt, ein Halbleitermodul bzw. dessen Zustand und Funktionsweise zu überwachen. Bei einer Überwachung eines Halbleitermoduls wie eines LED-Moduls ist dessen Temperatur von zentraler Bedeutung, da diese bzw. thermische Eigenschaften eine Lebensdauer des LED-Moduls bestimmen.

Es ist bekannt, beispielsweise durch eine thermische Impedanzanalyse eine Temperatur bzw. einen Temperaturverlauf eines LED-Moduls festzustellen. Hierzu werden ein Strom und/oder eine Spannung eines LED-Moduls als Funktion der Zeit insbesondere nach oder während eines Betriebszustandswechsels wie beispielsweise Ein- und Ausschalten gemessen. Daraus wird eine temperaturabhängige Diodenkennlinie gewonnen, aus welcher eine sogenannte Temperaturtransiente abgeleitet wird. Diese Temperaturtransiente gibt Auskunft über thermische Eigenschaften des LED-Moduls. Es wird weiter angenommen, dass ein solches Verfahren eine Wärmeausbreitung eines gesamten Systems in einem eindimensionalen Wärmepfad abbildet. Hierzu wird ein eindimensionaler Wärmepfad in kleine Blöcke aufgespalten, welche sowohl in Zeiteinheiten als auch in Entfernungen von einer Wärmequelle interpretiert werden.

Mit diesem bekannten Verfahren können zwar Fehlermoden identifiziert bzw. ein Fortschreiten bekannter Alterungsprozesse überwacht werden. Hiermit ist es jedoch nicht möglich, beobachtete Zustände bzw. Zustandsänderungen real existierenden Punkten des LED-Moduls zuzuordnen. Es wird nämlich eine Wärmeausbreitung über das gesamte System in einem einzelnen Wärmepfad zusammengefasst. Dies mag zwar ausreichend sein, um signifikante und/oder bekannte Effekte lokalisieren zu können. Eine eindeutige Zuordnung von Effekten zu beispielsweise verschiedenen Lötstellen ist dadurch jedoch nicht möglich.

Um diesen Nachteil zu überwinden, ist es bekannt, thermische Modelle zu simulieren. Dabei wird ein Ersatzschaltbild von thermischen Widerständen und Kapazitäten entworfen, mit welchem Aussagen über Zusammenhänge zwischen real existierenden Punkten eines Systems getroffen werden sollen. Ein solches thermisches Modell ist jedoch nicht dazu geeignet, eine Wärmeausbreitung in LED-Modulen zuverlässig voraussagen und interpretieren zu können, da die Wärmeausbreitung in LED-Modulen über komplizierte Pfade erfolgt, welche sich mit thermischen Modellen nicht genau genug erfassen lassen.

Aus der Publikation Wie Huang et al. "Parameterized Physical Compact Thermal Modeling", IEEE Transactions on Components and Packaging Technologies, Vol. 28, No. 4, 2005, Seiten 615-622 geht die Anwendung eines kompakten thermischen Modells für Halbleitermodule hervor, wobei das kompakte thermische Modell für funktionelle Einheiten oder unterteilte Gitter des Halbleitermoduls erstellt wird. Das so erstellte kompakte thermische Modell wird mit experimentellen Messdaten verglichen.

Aus der Veröffentlichung M. Mainka et al. "Messung von transienten thermischen Widerständen", www.elektroniknet.de/power/power-management/artikel/102189, 22. Oktober 2013, ist es bekannt, für IGBT-Module eine thermische Finite-Elemente-Methode anzuwenden und daraus gewonnenen Simulationsergebnisse daraus mit experimentellen Daten zu vergleichen. Es wurde gefunden, dass für eine Lebensdauervorhersage die Simulationsergebnisse genauer sind.

Hier setzt die Erfindung an. Aufgabe der Erfindung ist es, ein Verfahren der eingangs genannten Art anzugeben, mit welchem sowohl eine Temperatur eines Halbleitermoduls als auch eine thermische Anbindung des Halbleitermoduls an dessen Umgebung möglichst umfassend erfasst werden kann.

Diese Aufgabe wird erfindungsgemäß mit einem Verfahren nach Anspruch 1 gelöst.

Ein mit der Erfindung erzielter Vorteil ist insbesondere darin zu sehen, dass durch die thermische Impedanzmessung in Kombination mit aussagekräftigen kompakten thermischen Modellen eine echtzeitfähige Zustandsüberwachung von einem Halbleitermodul an oder nahe an demselben erreicht wird. Dadurch können zuverlässige Aussagen über eine Alterung von Grenzflächen eines Halbleitermodul-Systems getroffen werden. Solche Aussagen sind zentral für eine Abschätzung einer Lebensdauer eines Halbleitermoduls wie eines LED-Moduls. Zur Messung von thermischen Impedanzen wird beispielsweise ein Prozessor mit einem Sensor beim Halbleitermodul angeordnet, von welchem Strom- und/oder Spannungswerte gemessen werden. Es kann auch vorgesehen sein, dass weitere Betriebsparameter wie eine Temperatur, ein Luftvolumen und eine Luftfeuchtigkeit von einem Sensor oder dergleichen aufgenommen werden. Das erfindungsgemäße Verfahren kann beispielsweise auch zur Qualitätskontrolle einer Produktion von Halbleitermodulen oder zur Kontrolle eines Ersteinbaus derselben verwendet werden.

Das theoretische Modell wird üblicherweise vorab mittels einer geeigneten Simulation und genügender Kenntnis über einen inneren Aufbau eines Halbleitermoduls und eines Bauteils, in welchem das Halbleitermodul verbaut ist, gewonnen. Hierzu können thermische Kennwerte und gegebenenfalls Materialeigenschaften des Halbleitermoduls einfließen. Zum Validieren des theoretischen Modells wird eine direkte experimentelle Rückkopplungsschleife zu einer schrittweisen Anpassung von Simulationsergebnissen eingesetzt, wodurch das theoretische Modell andauernd mit Messwerten abgeglichen wird. Es wird somit ein validiertes bzw. kalibriertes Modell erzeugt. Darüber hinaus werden die gemessenen Betriebsparameter vom theoretischen Modell zu Informationen verarbeitet.

Das kompakte thermische Modell stellt ein Netzwerk von thermischen Widerständen dar, welche wiederum einen komplexen 3-D-Wärmestrom in einem realen Halbleitermodul darstellen, wobei das kompakte thermische Modell über einen analytischen Prozess hergeleitet wird, an welchen ein statistischer Optimierungsprozess anschließt. Um ein solches Modell effizient zu gestalten, besteht dieses aus einer relativ kleinen Anzahl an Knotenpunkten. Dabei entspricht jeder Knotenpunkt einer einzigen Temperatur, welche entweder an einer Oberfläche oder im Inneren des Halbleitermoduls anliegt. Auch Fehlerabschätzungen werden vom kompakten thermischen Modell selbst durchgeführt. Mit dem erfindungsgemäßen Verfahren ist es möglich, einen thermischen Istzustand des Halbleitermoduls und einer Umgebung bzw. eines Bauteils, in welchem das Halbleitermodul eingebettet ist, zu prüfen. Darüber hinaus werden dadurch das zukünftige Verhalten sowie eine Lebensdauer eines Halbleitermoduls bzw. eines Bauelementes mit dem Halbleitermodul zuverlässig vorausgesagt bzw. abgeschätzt. Das kompakte thermische Modell ist echtzeitfähig, was eine kontinuierliche Überwachung z. B. eines LED-Moduls erlaubt. Es werden weiter thermische Veränderungen in einem Halbleitermodul so exakt wie möglich lokalisiert und eine Art bzw. Ursache der thermischen Veränderung festgestellt.

Erfindungsgemäß wird das kompakte thermische Modell mit dem validierten theoretischen Modell bewertet. Hierzu wird aus dem theoretischen Modell, welches mit den Messwerten validiert wurde, ein validiertes theoretisches Modell erstellt. Dadurch wird das kompakte thermische Modell immer wieder mit Daten aus dem mit Messwerten validierten theoretischen Modell gefüttert, wodurch ein Zustand bzw. eine Lebensdauer des Halbleitermoduls noch genauer überwacht bzw. vorausgesagt werden kann.

Es ist weiter vorteilhaft, wenn das kompakte thermische Modell invertiert wird. Dadurch wird das kompakte thermische Modell in Relation mit thermischen Daten gesetzt, sodass eine Messkurve als Veränderung in einem Bauteil eines Halbleitermoduls interpretiert wird. In der Praxis wird dafür das Halbleitermodul bzw. das Bauteil in einem ersten Schritt geheizt, woraus Daten für eine Simulation des Halbleitermoduls gewonnen werden.

Günstig ist es, wenn Materialmodelle des Halbleitermoduls in das kompakte thermische Modell eingefügt werden, wobei diese mit dem kompakten thermischen Modell verglichen werden. Dadurch wird eine echtzeitfähige Überwachung des Halbleitermoduls möglich, wobei eine Ausführzeit festgelegt werden kann. Diese ist abhängig von einer Anwendung und beispielsweise geringer als eine Sekunde. Zumindest ist die Ausführzeit des erfindungsgemäßen Verfahrens um ein bis zwei Größenordnungen schneller als Ausführzeiten von Verfahren, welche aus dem Stand der Technik bekannt sind. Durch eine Kombination des kompakten thermischen Modells mit den Messwerten und den Materialmodellen kann ein Zustand eines beliebigen Halbleitermoduls zuverlässig überwacht und festgestellt bzw. vorausgesagt werden. Die Materialmodelle werden einerseits aus Erfahrungswerten und andererseits aus theoretischen Modellen gewonnen.

Es ist von Vorteil, wenn thermische und mechanische Modelle gekoppelt werden. Zudem kann vorgesehen sein, dass auch elektrische Modelle mit den thermischen und/oder mechanischen Modellen gekoppelt werden. Dadurch werden auch mechanische und/oder elektrische Eigenschaften des Halbleitermoduls bestimmt. Wird ein mechanisches Modell mit dem kompakten thermischen Modell gekoppelt, dann wird dieses zu einem kompakten thermisch-mechanischen Modell erweitert. Dadurch werden nicht nur thermische Eigenschaften eines Halbleitermoduls überwacht bzw. eine Lebensdauer desselben aufgrund von thermischen Effekten, sondern auch mechanische Eigenschaften bzw. deren Kopplung mit thermischen Eigenschaften und Effekten vorausgesagt.

Vorteilhaft ist es, wenn das kompakte thermische Modell in zumindest einer Auswerteeinheit integriert wird, wobei die zumindest eine Auswerteeinheit im oder am Halbleitermodul angeordnet wird. Das Halbleitermodul wird somit unmittelbar bei demselben überwacht, wobei die zumindest eine Auswerteeinheit mit Vorteil beim bzw. innerhalb des Halbleitermoduls angeordnet und somit ein eingebettetes System geschaffen wird. Die Auswerteeinheit kann als Prozessor ausgebildet sein.

Nicht Teil der Erfindung ist eine Vorrichtung zur Überwachung eines Halbleitermoduls, insbesondere eines LED-Moduls, umfassend zumindest eine Schaltungsanordnung und zumindest eine Auswerteeinheit, wobei die zumindest eine Schaltungsanordnung und die zumindest eine Auswerteeinheit im Halbleitermodul, insbesondere im LED-Modul, integriert sind.

Ein damit erzielter Vorteil ist insbesondere darin zu sehen, dass durch die kompakte Messanordnung eine direkte Qualitätsprüfung durchführbar ist, wobei die zumindest eine Schaltungsanordnung und die zumindest eine Auswerteeinheit im Halbleitermodul eingebettet bzw. eingebunden sind. Mit Vorteil wird beispielsweise ein Leuchtensystem mit integriertem Aufbau geschaffen. Insbesondere bei einer Durchführung eines erfindungsgemäßen Verfahrens ist die kompakte Mess- und Auswerteanordnung günstig, da dadurch ein theoretisches Modell, welches mit Vorteil in der Schaltungsanordnung integriert ist, unmittelbar mit Messwerten vergleichbar ist. Durch die Kombination einer Schaltungsanordnung bzw. einer Messschaltung und einer Auswerteeinheit auf kleinstem Raum ist eine Integration der Vorrichtung in typische Produkte wie beispielsweise LED-Straßenlampen, Autoscheinwerfer oder LED-Spots möglich.

Zweckmäßigerweise sind einer oder mehrere Prozessoren als Schaltungsanordnungen vorgesehen, sodass verschiedene Messgrößen wie Spannung, Strom, Temperatur, Luftvolumen und/oder Luftfeuchtigkeit von denselben messbar sind. Es kann auch vorgesehen sein, dass zumindest eine Schaltungsanordnung und eine Auswerteeinheit in einem oder mehreren Prozessoren eingebettet und somit in einer Recheneinheit miteinander verbunden sind. Die Prozessoren steuern weiter das theoretische Modell und verarbeiten Messdaten in diesem. Dadurch entsteht in weiterer Folge ein kompaktes thermisches Modell, welches einen Zustand des Halbleitermoduls erkennt und eine Lebensdauer desselben voraussagt. Darüber hinaus ist eine Alterung von Grenzflächen eines Halbleitermodul-Systems zuverlässig voraussagbar.

Hierzu ist es günstig, wenn zumindest eine Schaltungsanordnung zur Messung von thermischen Impedanzen des Halbleitermoduls vorgesehen ist. Hierzu misst insbesondere ein Prozessor, welcher beispielsweise einen Sensor umfasst, Spannungs- und Stromwerte in Abhängigkeit einer Zeit. Solche thermischen Impedanzmessungen zeigen Veränderungen in einem thermischen Management des Halbleitermoduls bzw. eines Bauteils mit einem Halbleitermodul und bieten somit einen Blick in ein Inneres des Halbleitermoduls ohne dieses zu beschädigen bzw. zu verändern.

Es ist von Vorteil, wenn in zumindest einer Auswerteeinheit ein kompaktes thermisches Modell zur Darstellung eines Wärmestroms im Halbleitermodul integriert ist. Somit erfolgt nicht nur die Messung der thermischen Impedanzen in Echtzeit, sondern auch deren Interpretation und in weiterer Folge eine Voraussage über eine Lebensdauer des Halbleitermoduls. Die Auswerteeinheit kann auch im selben Prozessor integriert sein wie die Schaltungsanordnung.

Weitere Merkmale, Vorteile und Wirkungen ergeben sich aus den nachfolgend dargestellten Ausführungsbeispielen. In den Zeichnungen, auf welche dabei Bezug genommen wird, zeigen:
Fig. 1 ein schematisches Flussdiagramm eines erfindungsgemäßen Verfahrens;
Fig. 2 ein schematisches Flussdiagramm eines weiteren erfindungsgemäßen Verfahrens;
Fig. 3 eine Vorrichtung.

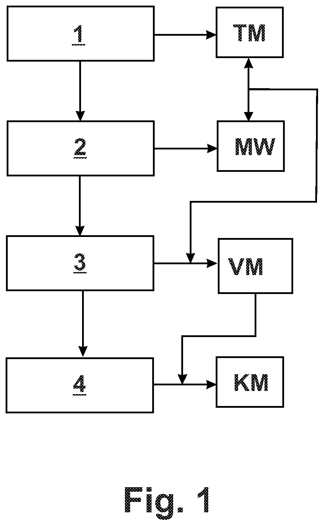

Fig. 1 zeigt ein schematisches Flussdiagramm eines erfindungsgemäßen Verfahrens zur Überwachung eines Halbleitermoduls HM. In einem ersten Verfahrensschritt 1 wird hierbei ein theoretisches Modell TM des Halbleitermoduls HM erstellt, wobei das Halbleitermodul HM insbesondere ein LED-Modul ist. Durch eine geeignete Simulation des Halbleitermoduls HM und somit mit einem geeigneten theoretischen Modell TM wird eine sogenannte Strukturfunktion ermittelt, welche in weiterer Folge interpretiert wird.

In einem zweiten Verfahrensschritt 2 werden thermische Impedanzen des Halbleitermoduls HM gemessen bzw. bestimmt und somit Messwerte MW aufgenommen. Hierzu werden üblicherweise von einem Prozessor mit beispielsweise einem Sensor Strom- und/oder Spannungswerte in Abhängigkeit einer Zeit gemessen, woraus eine Temperatur bestimmt wird. Das theoretische Modell TM wird wiederholt mit den Messwerten MW verglichen und validiert, wodurch in einem dritten Verfahrensschritt 3 ein validiertes Modell VM erstellt wird. Hierbei wird eine experimentelle Rückkopplungsschleife zur schrittweisen Anpassung des theoretischen Modells TM eingesetzt, wodurch ein Validierungsablauf erzeugt wird.

Es wird in weiterer Folge in einem vierten Verfahrensschritt 4 durch einen ständigen Abgleich des validierten Modells VM mit den Messwerten MW bzw. dem theoretischen Modell TM ein kompaktes thermisches Modell KM erstellt, welches einen Wärmestrom im Halbleitermodul HM darstellt. Um einen möglichst originalgetreuen Wärmestrom im Halbleitermodul HM zu simulieren bzw. eine Zuordenbarkeit zu echten Punkten bzw. Positionen im Halbleitermodul HM zu ermöglichen, wird das kompakte thermische Modell KM stets mit dem validierten Modell VM bewertet, womit auch die Messwerte MW einfließen. Mit einem erfindungsgemäßen Verfahren wird ein kompaktes thermisches Modell KM zur Überwachung eines Halbleitermoduls HM und zur Voraussage eines Lebensdauer desselben erzeugt, welches echtzeitfähig, intelligent und direkt im Halbleitermodul HM anordenbar ist.

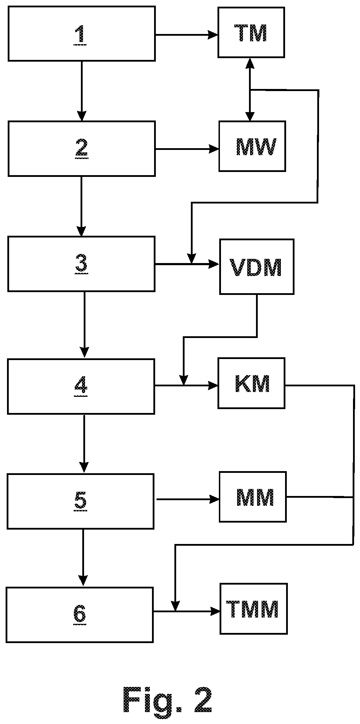

In Fig. 2 ist ein Flussdiagramm eines weiteren erfindungsgemäßen Verfahrens gezeigt. Die Verfahrensschritte 1 bis 4 entsprechen dem Verfahren gemäß Fig. 1. In einem fünften Verfahrensschritt 5 wird ein mechanisches Modell MM erzeugt, durch welches mechanische Eigenschaften des Halbleitermoduls HM bzw. eines Bauteils mit einem Halbleitermodul HM simuliert werden. In einem sechsten Verfahrensschritt 6 wird anschließend das kompakte thermische Modell KM mit dem mechanischen Modell MM zu einem kompakten thermisch-mechanischen Modell TMM erweitert. Mit dem kompakten thermisch-mechanischen Modell TMM wird nicht nur ein thermischer Zustand des Halbleitermoduls HM gemessen und vorausgesagt, sondern auch ein thermischmechanischer Zustand desselben.

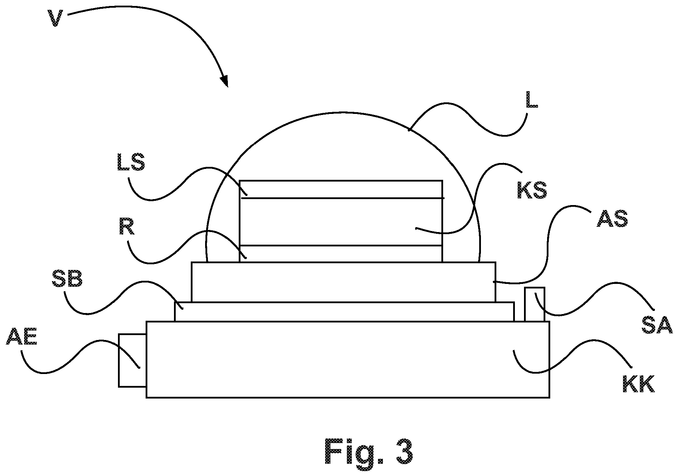

Eine Vorrichtung V ist in Fig. 3 gezeigt. Diese umfasst ein LED-Modul und zumindest eine Schaltungsanordnung SA und eine Auswerteeinheit AE. Das LED-Modul umfasst ein LED-Substrat LS, eine Klebeschicht KS, einen Reflektor R, ein Aluminiumsubstrat AS, eine Substratbefestigung SB und einen Kühlkörper KK, wobei diese Elemente schichtförmig aufgebaut sind. Außenseitig ist das LED-Modul mit einer Linse L abgeschlossen, wodurch das Licht der LED austritt. Die Anordnung der Schaltungsanordnung SA und der Auswerteeinheit AE in Fig. 3 ist nur symbolisch. Allerdings ist es vorgesehen, dass diese direkt beim LED-Modul angeordnet bzw. in demselben integriert sind, sodass ein eingebettetes System erzeugt ist. Die Schaltungsanordnung SA kann als oder auf einem Prozessor angeordnet sein. Darüber hinaus kann auch die Auswerteeinheit AE als Prozessor ausgeführt sein.

Die Vorrichtung V ist beispielsweise in einer Straßenbeleuchtungseinrichtung verbaut, welche durch das erfindungsgemäße Verfahren *in-line* überwacht wird. Darüber hinaus kann die Vorrichtung V auch während eines Herstellungsverfahrens eines Bauteils mit beispielsweise einem LED-Modul in dieses integriert werden, um einen einwandfreien Betrieb des Bauteils bzw. des LED-Moduls nach einer Fertigstellung desselben autonom und ohne Veränderungen an demselben festzustellen bzw. zu überprüfen. Weiter ist vorgesehen, dass die Vorrichtung V dazu verwendet wird, um eine korrekte Installation eines Lichtmoduls über insbesondere thermische Eigenschaften zu überprüfen.

## Patentansprüche

1. Verfahren zur Überwachung eines Halbleitermoduls (HM), insbesondere eines LED-Moduls, wobei ein theoretisches Modell (TM) des Halbleitermoduls (HM) mittels Simulation erstellt wird, wobei thermische Impedanzen des Halbleitermoduls (HM) bestimmt werden und somit Messwerte (MW) aufgenommen werden, wonach das theoretische Modell (TM) mit den Messwerten (MW) abgeglichen wird, **dadurch gekennzeichnet, dass** das theoretische Modell (TM) über eine direkte experimentelle Rückkopplungsschleife zu einer schrittweisen Anpassung von Simulationsergebnissen mit den Messwerten (MW) verglichen und dadurch ein validiertes theoretisches Modell (VM) erzeugt wird, wobei ein kompaktes thermisches Modell (KM) des Halbleitermoduls (HM) zur Darstellung eines Wärmestroms im Halbleitermodul (HM) erstellt wird, wobei das kompakte thermische Modell (KM) mit dem validierten theoretischen Modell (VM) stets bewertet wird, wobei das kompakte thermische Modell (KM) immer wieder mit Daten aus dem mit Messwerten (MW) validierten theoretischen Modell (VM) gefüttert wird, um einen thermischen Istzustand des Halbleitermoduls (HM) zu überwachen.

2. Verfahren nach Anspruch 1, **dadurch gekennzeichnet, dass** das kompakte thermische Modell (KM) mit einem mechanischen Modell des Halbleitermoduls (HM) sowie optional elektrischen Modellen gekoppelt wird, um mechanische und/oder elektrische Eigenschaften des Halbleitermodus (HM) zu bestimmen.

3. Verfahren nach einem der Ansprüche 1 oder 2, **dadurch gekennzeichnet, dass** das kompakte thermische Modell (KM) in zumindest eine im Halbleitermodul (HM) angeordnete Auswerteeinheit (AE) integriert wird.

## Claims

1. Method for monitoring a semiconductor module (HM), in particular an LED module, wherein a theoretical model (TM) of the semiconductor module (HM) is generated by means of simulation, wherein thermal impedances of the semiconductor module are determined and therefore measurements (MW) are recorded, after which the theoretical model (TM) is calibrated using the measurement values (MW), **characterized in that** the theoretical model (TM) is compared with the measurement values (MW) using a direct experimental feedback loop to obtain an incremental adjustment of simulation results, thereby generating a validated theoretical model (VM), wherein a compact thermal model (KM) of the semiconductor module (HM) is created to represent a heat flow in the semiconductor module (HM), wherein the compact thermal model (KM) is continuously evaluated with the validated theoretical model (VM), wherein the compact thermal model (KM) is repeatedly fed with data from the theoretical model (VM) validated with measurements (MW) in order to monitor a thermal actual state of the semiconductor module (HM).

2. Method according to claim 1, **characterized in that** the compact thermal model (KM) is coupled with a mechanical model of the semiconductor module (HM) and optionally with electrical models, in order to determine mechanical and electrical properties of the semiconductor module (HM).

3. Method according to either of claims 1 or 2, **characterized in that** the compact thermal model (KM) is integrated into at least one evaluation unit (AE) arranged in the semiconductor module (HM).

## Revendications

1. Procédé de surveillance d'un module à semi-conducteurs (HM), en particulier d'un module à diodes électroluminescentes, sachant qu'un modèle théorique (TM) du module à semi-conducteurs (HM) est établi au moyen d'une simulation, sachant que les impédances thermiques du module à semi-conducteurs (HM) sont déterminées et que les valeurs de mesure (MW) sont de ce fait enregistrées, le modèle théorique (TM) étant ainsi harmonisé avec les valeurs de mesure (MW), **caractérisé en ce que** le modèle théorique (TM) est comparé à des valeurs de mesure (MW) par le biais d'une boucle de réaction expérimentale directe par rapport à une adaptation progressive de résultats de simulation et **en ce qu'**un modèle théorique validé (VM) est produit, sachant qu'un modèle thermique compact (KM) du module à semi-conducteurs (HM) est établi pour représenter un flux thermique dans le module à semi-conducteurs (HM), sachant que le modèle thermique compact (KM) est toujours évalué avec le modèle théorique validé (VM), sachant que le modèle thermique compact (KM) est tout le temps alimenté avec des données provenant du modèle théorique validé (VM) avec des valeurs de mesure (MW) pour surveiller un état réel thermique du module à semi-conducteurs (HM).

2. Procédé de surveillance selon la revendication 1, **caractérisé en ce que** le modèle thermique compact (KM) est couplé à un modèle mécanique du module à semi-conducteurs (HM) ainsi qu'à des modèles électriques en option, pour déterminer les propriétés mécaniques et/ou électriques du module à semi-conducteurs (HM).

3. Procédé selon l'une quelconque des revendications 1 ou 2, **caractérisé en ce que** le modèle thermique compact (KM) est intégré dans au moins une unité d'évaluation (AE) disposée dans le module à semi-conducteurs (HM).
